# EUROPEAN PATENT APPLICATION

(11) **EP 3 393 124 A1**
(43) Date of publication of application: **24.10.2018**
(21) Application number: 16874698.0
(22) Date of filing: 22.11.2016
(51) Int. Cl.: H04N 9/04, H04N 5/225, H01L 27/148

(54) **IMAGING METHOD OF IMAGE SENSOR, IMAGING APPARATUS AND ELECTRONIC DEVICE**

(30) Priority: 14.12.2015 CN 201510925379
(71) Applicant: BYD Company Limited, Shenzhen, Guangdong 518118 (CN)
(72) Inventor: MAO, Shuijiang, Shenzhen Guangdong 518118 (CN); GUO, Xianqing, Shenzhen Guangdong 518118 (CN)
(74) Representative: Hoffmann Eitle
(86) International application number: PCT/CN2016/106800
(87) International publication number: WO 2017/101641

(57) **Abstract**

The present disclosure discloses an image forming method of image sensor, an image forming device and an electronic equipment. The image sensor includes a pixel array and a microlens array disposed on the pixel array, each four-adjacent-pixels of the pixel array includes one red pixel, one green pixel, one blue pixel, and one infrared pixel, the microlens array includes a plurality of microlenses and each microlens covers one pixel of the pixel array. The image forming method includes obtaining an output signal of each pixel of the pixel array, performing interpolation on the output signal of each pixel to obtain a red component, a green component, a blue component and an infrared component of each pixel, obtaining a type of current shooting scene, determining tricolor output values of each pixel according to the type of current shooting scene to generating an image according to the tricolor output values.

## Description

### CROSS REFERENCE TO RELATED APPLICATION

This application claims priority and benefits of Chinese Patent Application No. 201510925379.1, filed with State Intellectual Property Office, P. R. C. on December 14, 2015, the entire content of which is incorporated herein by reference.

### FIELD

Embodiments of the present disclosure generally relate to an imaging technology, and, more particularly, to an image forming method of an image sensor, an image forming device and an electronic equipment.

### BACKGROUND

In recent years, the development of image sensors has been advanced by leaps and bounds, the sales continue to rise, and the competition of the market is fierce. The prices of the image sensors are continuously dropping, while the demand for the quality of the image is increasing. In order to reduce the cost and the area of the sensor, the pixel size of the image sensor becomes smaller and smaller. The pixel size of the image sensor becomes smaller, which may influence the imaging quality of the sensor, especially, the lower-light effect of the sensor. When the pixel becomes smaller, the sensitivity of the image sensor becomes lower, and the lower-light brightness of the image is more insufficient. In order to increasing the lower light - brightness of the image, the solutions adopted in the related art include: 1. enhancing the analog gain or the digital gain; 2. adding a luminance to the image in the image processing section; 3. using all-pass lens, that is, the lens transmit both visible light and infrared light, in which, the visible light is visible to the human eyes, and infrared light refers to light whose wavelength is about 850nm and is invisible to the human eyes.

However, the above solutions have the following disadvantages:
(1) enhancing the analog gain or the digital gain means that multiply the image signal by a figure which is greater than one, thus the image signal can be amplified and then the bright degree of the image can be raised, however, while amplifying the image signal, the image noise would be amplified in a same multiple, such that the image is with a high-noise.
(2) adding a luminance to the image in the image processing section, adding a luminance to the entire image can increase the bright degree of the image in the poor lighting, however while adding luminance, contrast grade between image details and image non-details would be reduced, such that the image would be very blurry.
(3) using all-pass lens, while compared to ordinary lenses which only transmit the visible light, the all-pass lens can also transmit the infrared light, such that image sensor obtains a image with higher brightness, but the image is easily prone to color cast in the daytime.

### SUMMARY

Embodiments of the present disclosure seek to solve at least one of the problems existing in the related art to at least some extent. Therefore, a first purpose of the present disclosure is to provide an image forming method of image sensor, the image forming method improves brightness of an image shot in a dark scene, and a color cast of the image shot in a non-dark scene can be avoid, thus user experience can be improved.

A second purpose of the present disclosure is to provide an imagining device.

A third purpose of the present disclosure is to provide an electronic equipment.

In order to achieve the above purposes, the image forming method of image sensor according to the present disclosure, the image sensor includes a pixel array and a microlens array disposed on the pixel array, each adjacent-four- pixels of the pixel array includes one red pixel, one green pixel, one blue pixel, and one infrared pixel, the microlens array includes a plurality of microlenses and each microlens correspondingly covers each pixel of the pixel array, the image forming method includes following steps: obtaining an output signal of each pixel of the pixel array; performing interpolation on the output signal of each pixel to obtain a red component, a green component, a blue component and an infrared component of each pixel; obtaining a type of current shooting scene;
determining tricolor output values of each pixel according to the type of current shooting scene and generating an image according to tricolor output values.

The image forming method of image sensor according to the present disclosure improves brightness of an image shot in a dark scene, and a color cast of the image shot in a non-dark scene can be avoid, thus user experience can be improved.

In order to achieve the above purposes, the image forming device according to the present disclosure includes an image sensor including a pixel array, a microlens array disposed on the pixel array and an image processing module connected with the image sensor. Each adjacent-four- pixels of the pixel array includes one red pixel, one green pixel, one blue pixel, and one infrared pixel, the microlens array includes a plurality of microlenses and each microlens correspondingly covers each pixel of the pixel array and the image processing module is configured to obtain an output signal of each pixel of the pixel array, to perform interpolation on the output signal of each pixel to obtain a red component, a green component, a blue component and an infrared component of each pixel, and the image processing module is configured to obtain a type of current shooting scene and configured to determine tricolor output values of each pixel according to the type of current shooting scene to generate an image according to the tricolor output values.

The image forming device according to the present disclosure improves brightness of an image shot in a dark scene, and a color cast of the image shot in a non-dark scene can be avoid, thus user experience can be improved.

In order to achieve the above purposes, the electronic equipment according to the present disclosure includes the image forming device according to the present disclosure.

The electronic equipment according to the present disclosure improves brightness of an image shot in a dark scene, and a color cast of the image shot in a non-dark scene can be avoid, thus user experience can be improved.

### BRIEF DESCRIPTION OF THE DRAWINGS

Fig. 1 is a working flowchart of a CMOS image sensor;
Fig. 2 is a flowchart of an image forming method of image sensor according to an embodiment of the present disclosure;
Fig. 3 is a schematic diagram of response curve of pass of R,G,B,IR;
Fig. 4 is a schematic diagram of a Bayer array in the related art;
Fig. 5 is a schematic diagram of a pixel array of an image sensor according to an embodiment of the present disclosure;
Fig. 6 is a block schematic diagram of an image forming device according to an embodiment of the present disclosure;
Fig. 7 is a schematic diagram of microlens and pixel covered by the microlens according to an embodiment of the present disclosure;
Fig. 8 is a block schematic diagram of an electronic equipment according to an embodiment of the present disclosure.

### DETAILED DESCRIPTION

Exemplary embodiments will be described in detail herein, and examples thereof are illustrated in accompanying drawings. Reference will be made in detail to embodiments of the present disclosure. The embodiments described herein with reference to drawings are explanatory, illustrative, and used to generally understand the present disclosure. The embodiments shall not be construed to limit the present disclosure. The same or similar elements and the elements having same or similar functions are denoted by like reference numerals throughout the descriptions.

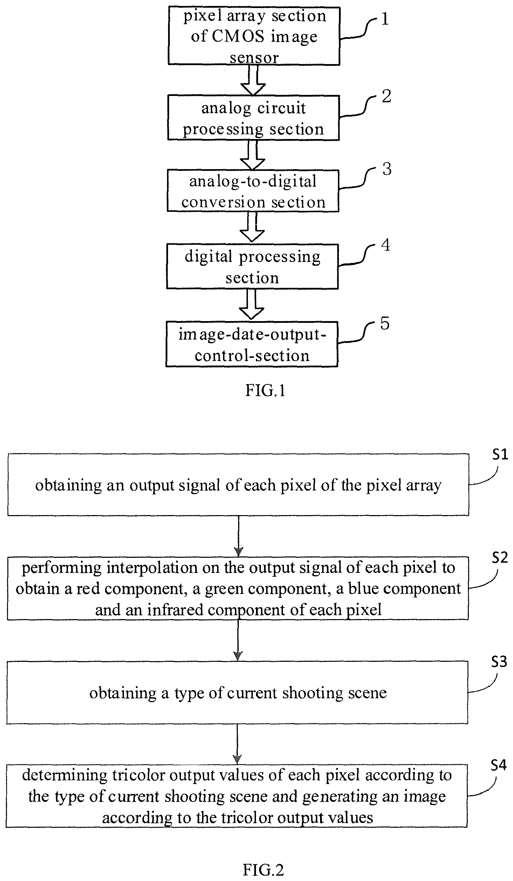

First, it is an introduction of working process of the CMOS image sensor in the related art. As shown in Fig.1, step 1: pixel array section of the image sensor converts light signals to electrical signals via photoelectric effect; step 2: the electrical signals are processed by analog-circuit-processing-section; step 3: analog electrical signals are converted into digital signals via analog-to-digital conversion section; step 4: the digital signals are processed by digital processing section; step 5: the digital signals are output to display on a monitor via an image-date-output-control-section.

The image forming method of image sensor, the imagining device and the electronic equipment according to embodiments of the present disclosure will be described in detail below by referring to the drawings.

Fig. 2 is a flowchart of an image forming method of image sensor according to an embodiment of the present disclosure. In which, the image sensor comprises a pixel array and a microlens array disposed on the pixel array, each adjacent-four-pixels of the pixel array includes one red pixel, one green pixel, one blue pixel, and one infrared pixel, the microlens array includes a plurality of microlenses and each microlens correspondingly covers each pixel of the pixel array.

In one embodiment, each pixel of the pixel array includes a filter and a photosensitive device covered by the filter. A red filter and the photosensitive device covered by the red filter constitute the red pixel, a green filter and the photosensitive device covered by the green filter constitute the green pixel, a blue filter and the photosensitive device covered by the blue filter constitute the blue pixel and the infrared filter and the photosensitive device covered by the infrared filter constitute the infrared pixel.

In one embodiment, the microlenses in correspondence to the red pixel, the green pixel and the blue pixel only allow the transmission of visible light, the microlenses in correspondence to the infrared pixel only allow the transmission of near-infrared light.

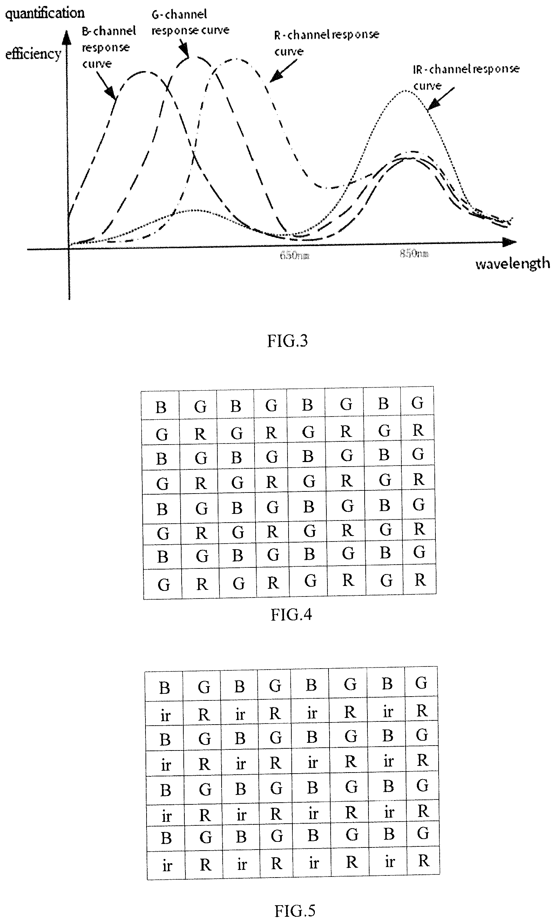

Specifically, in the process of designing and manufacturing an image sensor, the microlens of each pixel are required for special processing. For instance, microlenses on red pixel R, blue pixel B, green pixel G only transmit visible light with a wavelength less than 650nm, the microlens on infrared pixel ir only transmits the near-infrared light with a wavelength more than 650nm and about 850nm, as shown in Fig.3.

The image sensor pixel array commonly used in related art is Bayer array, as shown in Fig.4, B represents a blue component of a tricolor, G represents a green component of the tricolor and R represents a red component of the tricolor.

In one embodiment, the pixel array of the image sensor is as shown in Fig.5, that is, some green components in the Bayer array are replaced with the components ir which only sense infrared light.

Specifically, in Fig.5, R only transmits the red component of the visible light (R is configured to transmit the red component of the visible light band and without containing infrared component), G only transmits the green component of the visible light (G is configured to transmits the green component of the visible light band and without containing infrared component), B only transmits the blue component of the visible light (B is configured to transmits the blue component of the visible light band and without containing infrared component).

In one embodiment, the image sensor is CMOS image sensor.

As shown in Fig.2, the image forming method of image sensor includes:
S 1, obtaining an output signal of each pixel of the pixel array, that is, digital image signal of each pixel of the pixel array.

The CMOS image sensor is exposed, then the CMOS image sensor senses andoutputs an image-original-signal, each pixel of the image-original-signal only contains one color component. In which, the CMOS image sensor sensing and outputting image-original-signal is a photoelectric conversion process, the CMOS image sensor converts external light signal into electrical signal vie photodiodes, then the electrical signal is processing via the analog circuit, and then analog-to-digital converter converts analog signal into digital signal for subsequent digital signal processing.

In an embodiment, obtaining an output of signal each pixel of the pixel array means that obtaining digital image signal of each pixel of the pixel array, the output signal of each pixel only contains one color component, for instance, the output signal of the red pixel only contains red component.

S2, performing interpolation on the output signal of each pixel to obtain a red component, a green component, a blue component and an infrared component in correspondence to each pixel.

Specifically, because the output signal of each pixel only contains one color component, the output signal of each pixel is required to be performed interpolation processing to obtain four components R,G,B,ir of each pixel.

For instance, for the red pixel, the output signal of the red pixel only contains the red component R, interpolation processing is performed on the red pixel, then other color components G,B,ir can be obtained. Thus, after the interpolation processing, each pixel has four color components R,G,B,ir.

In one embodiment, performing interpolation processing on the output signal of each pixel is one of following interpolation methods: nearest neighbor interpolation, bilinear interpolation and edges-adaptive interpolation.

S3, obtaining a type of current shooting scene.

In one embodiment, obtaining a type of current shooting scene includes: obtaining an exposure time of the pixel array; determining whether the exposure time is larger than or equal to a preset exposure-time threshold; determining the current shooting scene is a dark scene when the exposure time is greater than or equal to the preset exposure-time threshold; determining the current shooting scene is a non-dark scene when the exposure time is less than the preset exposure-time threshold.

Specifically, image sensor exposure requires a certain time, the certain time is called exposure time T, longer the exposure time T is, higher the brightness of the image sensed by the image sensor is. For normal scene in daytime, due to bright ambient light, the image sensor only requires a short exposure time to achieve the desired brightness. However, for dark scene, for instance, the dark scene in night, the image sensor requires a longer time. Long exposure time means that it takes a long time for the image sensor to sense one image. In order to meet the requirements of frame rate (namely the number of images sensed in one second), exposure time has an upper limit Tth (namely the preset-exposure-time threshold), therefore, the exposure time T and the upper limit Tth can be compared to determine whether it is the dark scene or the non-dark scene. When the exposure time T is less than the upper limit Tth, it is the non-dark scene, on the contrary, it is the dark scene.

S4, determining tricolor output values of each pixel according to the type of current shooting scene to generating an image according to the tricolor output values.

In one embodiment, when the current shooting scene is the non-dark scene, the tricolor output values of each pixel is determined according to the red component, the green component and the blue component of each pixel. The image sensed by the image sensor is displayed on the monitor in a tricolor format. For the non-dark scene, the tricolor output values of each pixel are: R'=R, G'=G, B'=B.

In which, R', G' and B' respectively represent the tricolor output values of one pixel, R represents the red component of the one pixel, G represents the green component of the one pixel and B represents the blue component of the one pixel.

Thus, in the non-dark scene, R, G, B components which only allowing the transmission of the visible light are used, thus a color cast of the image in the non-dark scene can be avoid.

In one embodiment, when the current shooting scene is the dark scene, the tricolor output values of each pixel are determined according to the red component, the green component, the blue component and the infrared component of each pixel, that is, tricolor output values of each pixel is: R'=R+ir, G'=G+ir, B'=B+ir.

In which, R', G' and B' respectively represent tricolor output values of one pixel. R represents the red component in of the one pixel, G represents the green component of the one pixel, B represents the blue component of the one pixel and ir represents the infrared component of the one pixel.

Thus, the brightness of the image can be improved by superimposing the infrared component in the dark scene. Because the current monitoring products have a low demand for image color in the dark scene, and the brightness and clarity of the image are only valued, the image sensed via the image sensor in the dark scene is outputted in a format of black-and-white image.

Compared with the scheme of improving the brightness of the image in a poor lighting in related art, the advantages of the embodiments of the present disclosure are: when the shooting scene is the dark scene, the brightness of the image is improved from date sources, thus, the image noise would not be amplified. The embodiment of the present disclosure increases the light sensed by the image sensor rather than adds a luminance to the entire image, therefore, the image would not become blurry. In one embodiment, R, G, B tricolor which only allows the transmission of the visible light is used in the non-dark scene, that does not affect the color of the image, and the infrared component ir is added when in the dark scene, then the brightness of the image in a poor lighting can be improved. Thus, image quality can be greatly improved.

The image forming method of image sensor according to one embodiment greatly improves the brightness of the image shot in a poor lighting, and a color cast of the image shot in a non-dark scene can be avoid, thus the user experience can be improved.

In order to realize the above embodiments, the present disclosure also provides an image forming device.

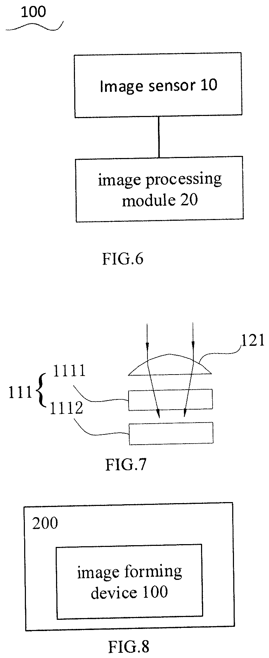

Fig. 6 is a block schematic diagram of an imagining device according to an embodiment of the present disclosure. As shown in Fig.6, the imagining device according to the present disclosure includes: an image sensor 10 and an image processing module 20.

In which, the image sensor includes a pixel array 11 and a microlens array 12 disposed on the pixel array 11.

As shown in Fig.5, each adjacent-four- pixels 111 of the pixel array 11 includes one red pixel R, one green pixel G, one blue pixel B, and one infrared pixel ir. That is, some green components in the Bayer array are replaced by the components ir which only sense infrared light.

The microlens array 12 disposed on the pixel array 11 includes a plurality of microlenses 121 and each microlens 121 correspondingly covers each pixel 111, as shown in Fig.7.

In one embodiment, each pixel 111 of the pixel array 11 includes a filter 1111 and a photosensitive device 1112 covered by the filter 1111, in which, a red filter and the photosensitive device covered by the red filter constitute the red pixel, a green filter and the photosensitive device covered by the green filter constitute the green pixel, a blue filter and the photosensitive device covered by the blue filter constitute the blue pixel and the infrared filter and the photosensitive device covered by the infrared filter constitute the infrared pixel.

In one embodiment, the microlenses in correspondence to the red pixel, the green pixel and the blue pixel only allow the transmission of visible light, the microlenses in correspondence to the infrared pixel only allow the transmission of near-infrared light.

Specifically, in the process of designing and manufacturing an image sensor 10, the microlens 121 of each pixel is required for special processing. For instance, the microlens 121 on red pixel R, blue pixel B, green pixel G only transmits visible light with a wavelength less than 650nm, the microlens 121 on infrared pixel ir only transmits the near-infrared light with a wavelength more than 650nm and about 850nm.

In one embodiment, the image sensor 10 is COMS image sensor.

An image processing module 20 connected with the image sensor 10 is configured to obtain an output of each pixel of the pixel array, and the image processing module 20 is also configured to perform interpolation processing on the output signal of each pixel to obtain a red component, a green component, a blue component and an infrared component of each pixel, and configured to obtain a type of current shooting scene and determine tricolor output values of each pixel according to the type of current shooting scene to generate an image according to the tricolor output values.

The image sensor 10 is exposed, then the image sensor 10 senses image-original-signal, each pixel of the image-original-signal only contains one color component. In which, the image sensor 10 sensing the image-original-signal is a photoelectric conversion process, the image sensor 10 converts external light signal into electrical signal vie photodiodes, then the electrical signal is processed via the analog circuit, and then analog-to-digital converter converts the analog signal into digital signal for the image processing module 20 to process.

Specifically, the image processing module 20 obtains an output signal of each pixel of the pixel array, the output signal of each pixel only contains one color component, for instance, the output signal of the red pixel only contains red component. Because the output signal of each pixel only contains one color component, interpolation processing is required to be performed on the output signal of each pixel to obtain four components R,G,B,ir of each pixel.

For instance, for the red pixel, the output signal of the red pixel only contains the red component R, the image processing module 20 performs interpolation processing on the red pixel, then other color components G,B,ir can be obtained. Thus, after the interpolation processing, each pixel has four color components R,G,B,ir.

In one embodiment, performing interpolation processing on the output signal of each pixel uses any one of following interpolation methods: nearest neighbor interpolation, bilinear interpolation and edges-adaptive interpolation.

Furthermore, the image processing module 20 obtains a type of current shooting scene, and determines tricolor output values of each pixel according to the type of current shooting scene and generates an image according to tricolor output values. The following gives describes in detail.

In one embodiment, the image processing module 20 obtains an exposure time of the pixel array and determines whether the exposure time is larger than or equal to a preset exposure-time threshold. The image processing module 20 determines the current shooting scene is a dark scene when the exposure time is greater than or equal to the preset exposure-time threshold, the image processing module 20 determines the current shooting scene is a non-dark scene when the exposure time is less than the preset exposure-time threshold.

Specifically, image sensor 10 exposure requires a certain time, the certain time is called exposure time T, longer the exposure time T is, higher the brightness of the image sensed by the image sensor is. For normal scene in daytime, due to bright ambient light, the image sensor 10 only requires a short exposure time to achieve the desired brightness. However, for dark scene, for instance, the dark scene in night, the image sensor 10 requires a longer time. Long exposure time means that it takes a long time for the image sensor 10 to sense one image. In order to meet the requirements of frame rate (namely the number of images sensed in one second), exposure time has an upper limit Tth (namely the preset exposure-time threshold), therefore, the exposure time T and the upper limit Tth can be compared to determine whether it is the dark scene or the non-dark scene. When the exposure time T is less than the upper limit Tth, it is the non-dark scene, on the contrary, it is the dark scene.

Furthermore, in one embodiment, when the current shooting scene is the non-dark scene, the image processing module 20 is configured to determine tricolor output values of each pixel according to the red component, the green component and the blue component in correspondence to each pixel. The image sensed by the image sensor 10 is displayed on the monitor in a tricolor format. For the non-dark scene, the tricolor output values of each pixel are: R'=R, G'=G, B'=B.

In which, R', G' and B' respectively represent the tricolor output values of one pixel, R represents the red component of the one pixel, G represents the green component of the one pixel and B represents the blue component of the one pixel.

Thus, in the non-dark scene, R, G, B components only allowing the transmission of the visible light are used, thus a color cast of the image in the non-dark scene can be avoided.

In one embodiment, when the current shooting scene is the dark scene, the image processing module 20 determines the tricolor output values of each pixel according to the red component, the green component, the blue component and the infrared component of each pixel, that is, the tricolor output values of each pixel are: R' =R+ir, G' =G+ir, B' =B+ir.

In which, R', G' and B' respectively represent the output value of the tricolor of one pixel. R represents the red component of the one pixel, G represents the green component of the one pixel, B represents the blue component of the one pixel and ir represents the infrared component of the one pixel.

Thus, the brightness of the image can be improved by superimposing the infrared component in the dark scene. Because the current monitoring products have a low demand for image color in the dark scene, and only the brightness and clarity of the image are valued, the image sensed by the image sensor in the dark scene is outputted in a format of black-and-white image.

The image forming device according to one embodiment greatly improves the brightness of the image shot in a poor lighting, and a color cast of the image shot in a non-dark scene can be avoid, thus the user experience can be improved.

In order to realize the above embodiments, the present disclosure also provides an electronic equipment 200, as shown in Fig.8, the electronic equipment 200 includes the imagining device 100 according to the present disclosure.

In one embodiment, the electronic equipment 200 is a monitoring equipment.

The electronic equipment 200 according to the present disclosure, due to including the image forming device, greatly improves the brightness of the image shot in a poor lighting, and a color cast of the image shot in a non-dark scene can be avoid, thus the user experience can be improved.

In the description of the present disclosure, it should be understood that, location or position relationships indicated by the terms, such as "center", "longitude", "transverse", "length", "width", "thickness", "up", "down", "front", "rear", "left", "right", "vertical", "horizontal", "top", "bottom", "within", "outside", "clockwise", "counterclockwise", "axial", "radial", and "circumferential" are location or position relationships based on illustration of the accompanying drawings, are merely used for describing the present disclosure and simplifying the description instead of indicating or implying the indicated apparatuses or elements should have specified locations or be constructed and operated according to specified locations, and Thereof, should not be intercepted as limitations to the present disclosure.

In addition, the terms such as "first" and "second" are used merely for the purpose of description, but shall not be construed as indicating or implying relative importance or implicitly indicating a number of the indicated technical feature. Hence, the feature defined with "first" and "second" may explicitly or implicitly include at least one of the features. In the description of the present disclosure, unless otherwise explicitly specifically defined, "multiple" means at least two, for example, two or three.

In the present disclosure, unless otherwise explicitly specified or defined, the terms such as "mount", "connect", "connection", and "fix" should be interpreted in a broad sense. For example, a connection may be a fixed connection, or may be a detachable connection or an integral connection; a connection may be a mechanical connection, or may be an electrical connection; a connection may be a mechanical connection, or may be an electrical connection, or may be used for intercommunication; a connection may be a direct connection, or may be an indirect connection via an intermediate medium, or may be communication between interiors of two elements or an interaction relationship between two elements, unless otherwise explicitly defined. It may be appreciated by those of ordinary skill in the art that the specific meanings of the aforementioned terms in the present disclosure can be understood depending on specific situations.

In the present disclosure, unless otherwise explicitly specified or defined, a first feature being "above" or "below" a second feature may be that the first and second features are in direct contact or that the first and second features in indirect contact by means of an intermediate medium. In addition, the first feature being "over", "above" or "on the top of' a second feature may be that the first feature is over or above the second feature or merely indicates that the horizontal height of the firs feature is higher than that of the second feature. The first feature being "underneath", "below" or "on the bottom of' a second feature may be that the first feature is underneath or below the second feature or merely indicates that the horizontal height of the first feature is lower than that of the second feature.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the present disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the present disclosure. Furthermore, the particular features, structures, materials, or characteristics may be combined in any suitable manner in one or more embodiments or examples.

Although the embodiments of the present disclosure have been shown and described, those of ordinary skill in the art can understand that multiple changes, modifications, replacements, and variations may be made to these embodiments without departing from the principle and purpose of the present disclosure.

## Claims

1. An image forming method of image sensor, wherein: the image sensor comprises a pixel array and a microlens array disposed on the pixel array, each adjacent four pixels of the pixel array includes one red pixel, one green pixel, one blue pixel, and one infrared pixel, the microlens array includes a plurality of microlenses and each microlens correspondingly covers each pixel of the pixel array, the image forming method comprising:
obtaining an output signal of each pixel of the pixel array;
performing interpolation on the output signal of each pixel to obtain a red component, a green component, a blue component and an infrared component of each pixel;
obtaining a type of current shooting scene;
determining tricolor output values of each pixel according to the type of current shooting scene and generating an image according to the tricolor output values.

2. The image forming method according to claim 1, wherein obtaining a type of current shooting scene comprises:
obtaining an exposure time of the pixel array;
determining whether the exposure time is larger than or equal to a preset exposure-time threshold;
determining that the current shooting scene is a dark scene when the exposure time is larger than or equal to a preset exposure-time threshold; and
determining that the current shooting scene is a non-dark scene when the exposure time is less than the preset exposure-time threshold.

3. The image forming method according to claim 2, wherein determining tricolor output values of each pixel according to the type of current shooting scene comprises:
determining the tricolor output values of each pixel according to the red component, the green component, the blue component and the infrared component of each pixel when the current shooting scene is the dark scene; and
determining the tricolor output values of each pixel according to the red component, the green component and the blue component of each pixel when the current shooting scene is the non-dark scene.

4. The image forming method according to claim 3, wherein when the current shooting scene is the non-dark scene, the tricolor output values of each pixel are determined according to a formula as follow:
R'=R, G'=G, B'=B,
wherein R', G' and B' represent the tricolor output values of one pixel, R represents the red component of the one pixel, G represents the green component of the one pixel and B represents the blue component of the one pixel.

5. The image forming method according to claim 3, wherein when the current shooting scene is the dark scene, the tricolor output values of each pixel are determined according to an equation formula R'=R+ir, G'=G+ir, B'=B+ir, wherein R', G' and B' represent the tricolor output values of one pixel, R represents the red component of the one pixel, G represents the green component of the one pixel, B represents the blue component of the one pixel and ir represents the infrared component of the one pixel.

6. The image forming method according to claim 2, wherein generating an image according to the tricolor output values comprises:
generating a color image according to the tricolor output values of each pixel when the current shooting scene is the non-dark scene; and
generating a black-and-white image according to the tricolor output values of each pixel when the current shooting scene is the dark scene.

7. The image forming method according to any one of claims 1 to 6, wherein each pixel of the pixel array includes a filter and a photosensitive device covered by the filter, wherein,
a red filter and the photosensitive device covered by the red filter constitute the red pixel, a green filter and the photosensitive device covered by the green filter constitute the green pixel, a blue filter and the photosensitive device covered by the blue filter constitute the blue pixel and the infrared filter and the photosensitive device covered by the infrared filter constitute the infrared pixel.

8. The image forming method according to any one of claims 1 to 7, wherein the microlenses respectively corresponding to the red pixel, the green pixel and the blue pixel only allow the transmission of visible light, the microlenses corresponding to the infrared pixel only allow the transmission of near-infrared light.

9. The image forming method according to any one of claims 1 to 8, wherein a interpolation method of performing interpolation on the output signal of each pixel is one of nearest neighbor interpolation, bilinear interpolation and edges-adaptive interpolation.

10. An image forming device, comprising:
a image sensor including a pixel array and a microlens array disposed on the pixel array, wherein:
each adjacent-four- pixels of the pixel array includes one red pixel, one green pixel, one blue pixel, and one infrared pixel;
the microlens array includes a plurality of microlenses and each microlens correspondingly covers each pixel of the pixel array; and
an image processing module connected with the image sensor, wherein the image processing module is configured to obtaining an output signal of each pixel of the pixel array, to perform interpolation on the output signal of each pixel to obtain a red component, a green component, a blue component and an infrared component of each pixel, and to obtain a type of current shooting scene and the image processing module is also configured to determine an tricolor output values of each pixel according to the type of current shooting scene and configured to generat an image according to the tricolor output values.

11. The image forming device according to claim 10, wherein the image processing module is configured to obtain an exposure time of the pixel array and determine whether the exposure time is larger than or equal to a preset exposure- time threshold, the image processing module determines the current shooting scene is a dark scene when the exposure time is greater than or equal to a preset exposure-time threshold, the image processing module determines the current shooting scene is a non-dark scene when the exposure time is less than the preset exposure-time threshold.

12. The image forming device according to claim 11, wherein the image processing module is configured to determine the tricolor output values of each pixel according to the red component, the green component, the blue component and the infrared component of each pixelwhen the current shooting scene is the dark scene, and the image processing module is configured to determine the tricolor output values of each pixel according to the red component, the green component and the blue component of each pixel when the current shooting scene is the non-dark scene,.

13. The image forming device according to claim 12, wherein when the current shooting scene is the non-dark scene, the image processing module calculates tricolor output values of each pixel according to a formula R'=R, G'=G, B'=B, wherein R', G' and B' represent the tricolor output values of one pixel, R represents the red component of the one pixel, G represents the green component of the one pixel and B represents the blue component of the one pixel.

14. The image forming device according to claim 12, wherein when the current shooting scene is the dark scene, the image processing module calculates tricolor output values of each pixel according to an equation formula R'=R+ir, G'=G+ir, B'=B+ir, wherein R', G'and B' represent the tricolor output values of one pixel, R represents the red component of to the one pixel, G represents the green component of the one pixel, B represents the blue component of the one pixel and ir represents the infrared component of the one pixel.

15. The image forming device according to claim 11, wherein the image processing module is configured to generate a color image according to the tricolor output values of each pixel, when the current shooting scene is the non-dark scene, and configured to generate a black-and-white image according to the tricolor output values of each pixel when the current shooting scene is the dark scene.

16. The image forming device according to claim 10, wherein each pixel of the pixel array includes a filter and a photosensitive device covered by the filter, wherein:
a red filter and the photosensitive device covered by the red filter constitute the red pixel, a green filter and the photosensitive device covered by the green filter constitute the green pixel, a blue filter and the photosensitive device covered by the blue filter constitute the blue pixel and the infrared filter and the photosensitive device covered by the infrared filter constitute the infrared pixel.

17. The image forming device according to claim 10, wherein the microlenses in correspondence to the red pixel, the green pixel and the blue pixel only allow the transmission of visible light, the microlenses in correspondence to the infrared pixel only allow the transmission of near-infrared light.

18. The image forming device according to claim 10, wherein the image processing module performs interpolation on the output signal of each pixel , and interpolation method is one of nearest neighbor interpolation, bilinear interpolation and edges-adaptive interpolation.

19. An electronic equipment comprises the image forming device according to any one of claims 10 to 18.

20. The electronic equipment according to claim 19, wherein the electronic equipment comprise a monitoring equipment.
